Europäisches Patentamt

European Patent Office

Office européen des brevets

(11) Veröffentlichungsnummer: **0 359 922**
**A1**

## EUROPÄISCHE PATENTANMELDUNG

(21) Anmeldenummer: 89112102.2

(22) Anmeldetag: 03.07.89

(51) Int. Cl.5: **G01R 33/02**

(30) Priorität: 13.09.88 CH 3413/88

(43) Veröffentlichungstag der Anmeldung:
28.03.90 Patentblatt 90/13

(84) Benannte Vertragsstaaten:
CH DE ES FR GB IT LI

(71) Anmelder: **Landis & Gyr Betriebs AG**

**CH-6301 Zug(CH)**

(72) Erfinder: **Popovic, Radivoje**
**Fridbach 1**
**CH-6300 Zug(CH)**
Erfinder: **Seitz, Thomas**
**Hasenbühlweg 7**
**CH-6300 Zug(CH)**

(54) **Vorrichtung zur Messung eines magnetischen Feldes.**

(57) Beim Messen von schwachen magnetischen Feldern bilden das 1/f Rauschen und der Offset von Sensor und Verstärkerelementen die untere Messgrenze. Die Zerhackertechnik ist eine in der Messtechnik bekannte Methode zur Elimination von Rauschen und Offset. Erfindungsgemäss wird vorgeschlagen, mit einer steuerbaren Abschirmung (2) das zu messende Magnetfeld ($H_a$) zu zerhacken. Durch eine Erregerspule (3) wird die Abschirmung (2) periodisch in die Sättigung getrieben. Die ungesättigte Abschirmung (2) schirmt den Magnetfeldsensor (1) vollstandig vom Magnetfeld ($H_a$) ab. Von der gesättigten Abschirmung (2) wird das Magnetfeld ($H_a$) nicht gestört. Die Vorrichtung dient vorteilhaft zur Messung elektrischer Leistung in statischen Elektrizitätszählern.

# Fig. 1

## Vorrichtung zur Messung eines magnetischen Feldes

Die Erfindung bezieht sich auf eine Vorrichtung zur Messung eines magnetischen Feldes der im Oberbegriff des Anspruchs 1 genannten Art.

Eine Vorrichtung zum Messen eines magnetischen Feldes der im Oberbegriff des Anspruchs 1 genannten Art ist aus der DE-OS 2 921 546 bekannt. Diese Vorrichtung verwendet als Magnetfeldsensor ein Hall-Element. Um die Empfindlichkeit zu steigern, wird das Hall-Element nicht dauernd, sondern impulsweise gespeist. Die Amplitude des impulsweise zugeführten Stromes kann grösser gewählt werden als die Amplitude des höchstzulässigen Dauerstromes. Sie ist begrenzt durch die Strom-Zeitfläche, die nicht grösser werden darf als die Strom-Zeitfläche bei Dauerstrom. Die pulsförmige Ausgangsspannung des Hall-Elementes wird verstärkt, gleichgerichtet und einem Messinstrument zugeführt.

Es ist eine weitere Vorrichtung zur Messung eines magnetischen Feldes bekannt (EP-OS 0 157 470), die auf dem allgemein bekannten Prinzip der Förstersonde aufgebaut ist. Wie bei der Förstersonde wird ein Eisenkern periodisch in die Sättigung getrieben. Anstelle der Messwicklung ist aber ein Hall-Element eingesetzt, das in einem Luftspalt des Eisenkernes angeordnet ist. Wird diese Vorrichtung einem magnetischen Feld ausgesetzt, entstehen wie bei der Förstersonde im Ausgangssignal geradzahlige Harmonische, die ausgewertet werden. Durch die periodische Sättigung des Eisenkerns wird die Messgrösse zerhackt. Dadurch ergibt sich eine Rauschunterdrückung und Elimination des Offset des Hall-Elementes. Der Erregerstrom muss allerdings gross gewählt werden, da im Magnetkreis mindestens ein Luftspalt vorhanden sein muss, um das Hall-Element aufzunehmen.

Beim Messen von kleinen nichtelektrischen Grössen über grössere Zeiträume machen sich das sogenannte 1/f Rauschen und der Offset der Sensor- und Verstärkerelemente stark bemerkbar. Eine in der Messtechnik bekannte Methode, um das Rauschen und den Offset von Gleichspannungsverstärkern zu eliminieren, ist die Zerhackertechnik. Die zu verstärkende kleine Gleichspannung wird zunächst durch einen Unterbrecher in eine Rechteckspannung umgeformt, deren Amplitude derjenigen der Eingangsspannung entspricht. Die gewonnene Spannung wird wie eine Wechselspannung verstärkt. Bei Wechselspannungsverstärkern bleiben Verschiebungen der Arbeitspunkte in weiten Grenzen ohne Einfluss, selbst wenn die Verstärkung bis zur Rauschgrenze erhöht wird. Die verstärkte Rechteckspannung wird gleichgerichtet und einem Anzeigeinstrument zugeführt. Diese Technik wird beispielsweise in "Elektronik ohne

Ballast" von Otto Limann (4. Auflage S.139) Franzis-Verlag München beschrieben.

Beim Messen von Magnetfeldern mit Magnetfeldsensoren im DC-Verfahren wird die Messgenauigkeit durch Rauschen und Offset der Sensoren stark beeinträchtigt. Insbesondere die untere Messgrenze wird durch das 1/f Rauschen angehoben und dadurch die Messempfindlichkeit entsprechend verkleinert.

Der Erfindung liegt die Aufgabe zugrunde, eine Vorrichtung zum Messen eines magnetischen Feldes zu schaffen, bei der die Einflüsse von Rauschen und Offset des Magnetfeldsensors weitgehend eliminiert sind und die einen sehr geringen Eigenverbrauch aufweist.

Die Erfindung besteht in den im Kennzeichen des Anspruchs 1 angegebenen Merkmalen. Vorteilhafte Ausgestaltungen ergeben sich aus den Unteransprüchen.

Nachfolgend werden Ausführungsbeispiele der Erfindung anhand der Zeichnungen näher erläutert.

Es zeigen:

Fig. 1 einen Magnetfeldsensor mit zylinderförmiger Abschirmung und Erregerspule,

Fig. 2 einen Magnetfeldsensor mit ungesättigter Abschirmung,

Fig. 3 einen Magnetfeldsensor mit gesättigter Abschirmung,

Fig. 4 ein Diagramm von Erregerstrom und Magnetfeld,

Fig. 5 einen Magnetfeldsensor mit geschlossener, flacher Abschirmung,

Fig. 6 einen Magnetfeldsensor mit offener, flacher Abschirmung,

Fig. 7 einen Magnetfeldsensor mit Abschirmung in Hybridtechnik,

Fig. 8 einen Magnetfeldsensor mit Abschirmung in integrierter Technik,

Fig. 9 einen Magnetfeldsensor mit in einer Stromschlaufe angeordneter Abschirmung und

Fig. 10 ein Blockdiagramm einer vollständigen Messanordnung.

Gleiche Bezugszahlen bezeichnen in allen Figuren gleiche oder gleichartige Teile.

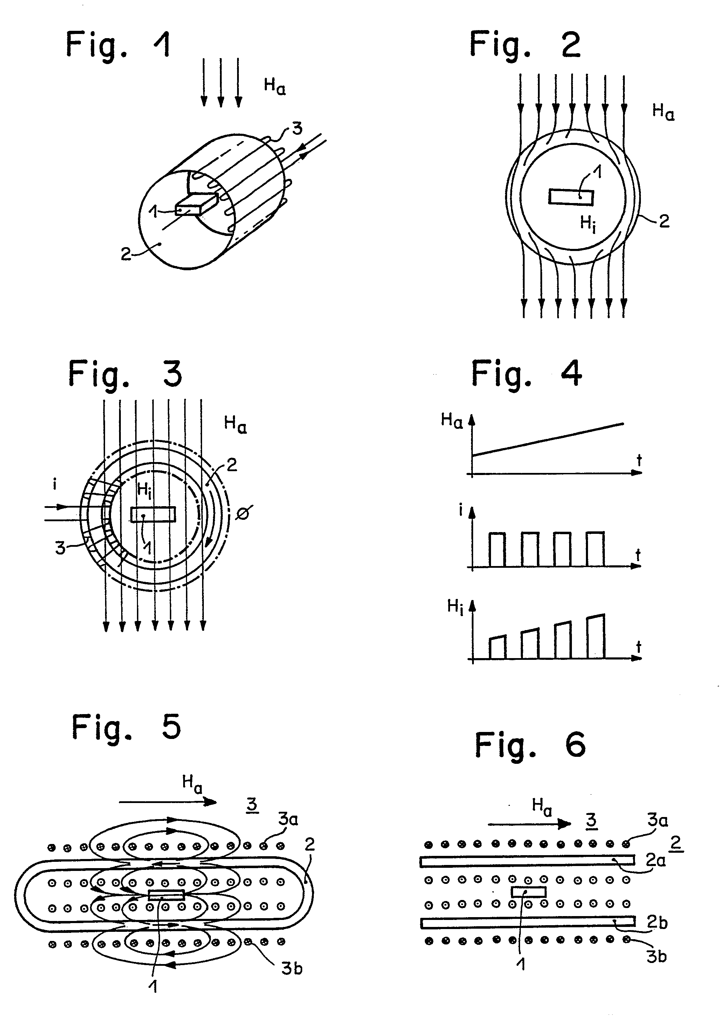

In der Fig. 1 ist eine Vorrichtung mit einem Magnetfeldsensor 1, einer Abschirmung 2 und einer Erregerspule 3 aufgezeichnet. Die Abschirmung 2 bildet einen zylinderförmigen Hohlkörper, der den Magnetfeldsensor 1 umschliesst. Der Magnetfeldsensor 1 ist im Zentrum der Abschirmung 2 angeordnet. Die Erregerspule 3 ist toroidförmig und gleichmässig um den vollen Umfang der Abschirmung 2 gewickelt. Die Abschirmung 2 besteht aus einem magnetisch gut leitenden Material, z. B. Mumetall, und ist ohne Luftspalt zu einem Zylinder geformt. Die Länge des Zylinders ist so bemessen, dass der Magnetfeldsensor 1 vollständig von einem quer zum Zylinder verlaufenden Magnetfeld $H_a$ abgeschirmt wird.

Die Fig. 2 zeigt, wie das Magnetfeld $H_a$ von der Abschirmung 2 um den Magnetfeldsensor 1 herum abgeleitet wird. Das Magnetfeld $H_i$ im inneren der Abschirmung 2 ist gleich Null.

In der Fig. 3 wird die Erregerspule 3, die um den vollen Umfang der Abschirmung 2 gewickelt ist, von einem Strom i erregt. Der Strom i treibt den Fluss Ø durch die Abschirmung 2. Da die Abschirmung 2 eine grosse Permeabilität aufweist und ohne Luftspalt ausgeführt ist, genügt schon ein sehr kleiner Strom i, um die Abschirmung 2 vollständig in die Sättigung zu treiben. Die gesättigte Abschirmung 2 ist nun nicht mehr in der Lage, vom Magnetfeld $H_a$ einen Flussanteil zu übernehmen. Das Magnetfeld $H_a$ wird von der Abschirmung 2 nicht mehr gestört und verläuft so als ob keine Abschirmung 2 vorhanden wäre. Das Magnetfeld $H_i$ entspricht also nach Grösse und Richtung dem Magnetfeld $H_a$. Der Magnetfeldsensor 1 ist damit der vollen Feldstärke des Magnetfeldes $H_a$ ausgesetzt. Die Abschirmung 2 und damit das Magnetfeld $H_i$ im inneren der Abschirmung 2 werden also durch den Strom i gesteuert. Von der Erregerspule 3 ausgehende Streufelder kompensieren sich im Zentrum der Abschirmung 2 gegenseitig und beeinflussen den Magnetfeldsensor 1 nicht.

Die steuerbare magnetische Abschirmung 2 schirmt also den Magnetfeldsensor 1 zeitweise von dem zu messenden Magnetfeld $H_a$ ab. Das Ausgangssignal des Magnetfeldsensors 1 ist rechteckförmig, von gleicher Frequenz wie der Erregerstrom i und in der Amplitude proportional dem Magnetfeld $H_a$. Durch das Zerhacken des Magnetfeldes $H_a$ wird die Messung auf einen Frequenzbereich verlegt, wo das Rauschen nur noch thermischer Natur ist. Das bei tiefen Frequenzen vorherrschende 1/f Rauschen wird eliminiert und dadurch die untere Messgrenze erweitert. Gleichzeitig wird auch der Offset des Magnetfeldsensors 1 eliminiert.

In der Fig. 4 ist der Sachverhalt in einem Diagramm dargestellt. In den Zeitpunkten, in denen der Strom i Null ist, ist auch das Magnetfeld $H_i$ innerhalb der Abschirmung 2 Null. Wenn der Strom i die Abschirmung 2 aussteuert, erreicht das Magnetfeld $H_i$ den vollen Wert des Magnetfeldes $H_a$. Die Remanenz des für die Abschirmung 2 verwendeten Materials bleibt ohne Einfluss auf diesen Vorgang. Es sind auch andere Impulsformen des Stromes i als die in der Zeichnung dargestellte Rechteckform möglich. Die Impulsfrequenz des Stromes i kann je nach Anwendung in weiten Grenzen streuen. Bei einem gleichförmigen Magnetfeld $H_a$ kann die Impulsfrequenz wenige Hz betragen, bei einem wechselförmigen Magnetfeld $H_a$ muss die Impulsfrequenz ein Mehrfaches der Frequenz des Magnetfeldes $H_a$ betragen. Die obere Grenzfrequenz ist durch Skineffekt, Wirbelstromverluste und Spinrelaxationseffekt des magnetischen Materials gegeben.

Die nachfolgenden Figuren 5 bis 8 zeigen weitere vorteilhafte Ausführungsformen der Messanordnung.

In der Fig. 5 weist die Abschirmung 2 eine flache, in sich geschlossene Form auf. Die beiden Flachseiten der Abschirmung 2 und die Flachseite des Magnetfeldsensors 1 sind parallel zum Magnetfeld $H_a$ angeordnet. An der Stelle des in der Längsrichtung empfindlichen Magnetfeldsensors 1 kompensieren sich gegenseitig die Streufelder, die von der oberen Hälfte 3a und der unteren Hälfte 3b der Erregerspule 3 ausgehen. Die Abschirmwirkung in Richtung des Magnetfeldes $H_a$ ist grösser als bei einer zylindrischen Ausführung. Diese Anordnung bietet ausserdem bei engen Platzverhältnissen Vorteile.

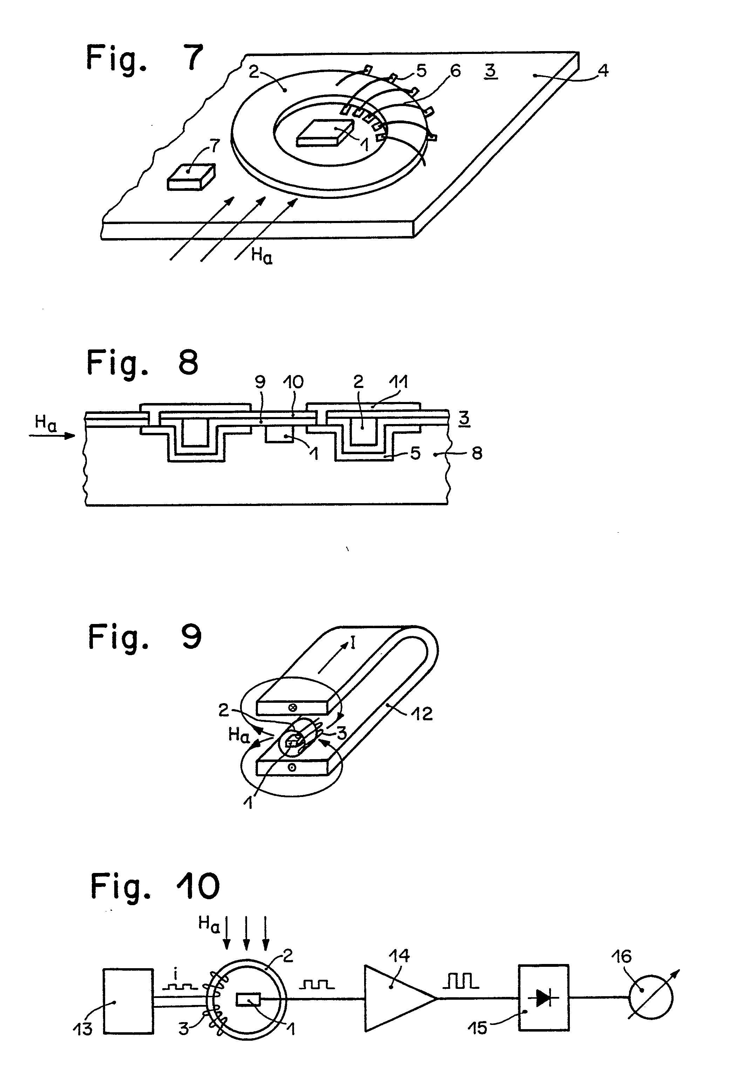

Die Fig. 6 zeigt eine weitere Ausführung der Messanordnung. Zwei im Verhältnis zu ihrer Länge dünne Schichten 2a, 2b aus magnetisch leitendem Material sind parallel zum Magnetfeld $H_a$ und so nahe wie möglich zueinander angeordnet und bilden die magnetische Abschirmung 2. Im Luftspalt zwischen den beiden dünnen Schichten 2a, 2b ist der in der Längsrichtung empfindliche Magnetfeldsensor 1 angeordnet. Die beiden dünnen Schichten 2a und 2b dienen als Flussleiter, die bei nicht erregter Spule 3 das Magnetfeld $H_a$ um den Magnetfeldsensor 1 herum ableiten. Da die Schichten 2a und 2b im Verhältnis zu ihrer Länge sehr dünn sind, weisen sie einen kleinen Entmagnetisierungsfaktor auf. Dadurch ist es möglich, eine offene Abschirmung herzustellen, ohne dass der notwendige Erregerstrom wesentlich ansteigt.

Die Fig. 7 zeigt eine Ausführung der Messanordnung in Hybridtechnik. Auf einem Keramiksubstrat 4 sind kurze Leiterbahnen in Form von Schwellen 5 aufgebracht. Die Schwellen 5 sind radial zu einem Kreisring angeordnet. Eine ringförmige Abschirmung 2 aus magnetisch leitendem Material, z. B. aus amorphem Metall (Metallglas), ist auf die Schwellen 5 aufgeklebt. Die Schwellen 5 und die Abschirmung 2 sind durch eine hier nicht gezeichnete Isolationsschicht getrennt. Gebondete Drähte 6 verbinden jeweils das innere Ende einer Schwelle 5 mit dem äusseren Ende einer nächsten Schwelle 5 und umschliessen dabei die Abschirmung 2. Die Gesamtheit der Schwellen 5 und der Drähte 6 bilden zusammen die toroidförmige Erregerwicklung 3. Ebenfalls auf dem Keramiksubstrat 4, im Zentrum der ringförmigen Abschirmung 2 ist der Magnetfeldsensor 1 angebracht. Der Magnetfeldsensor 1 misst Magnetfelder $H_a$, die parallel zum Keramiksubstrat 4 verlaufen. Weitere elektronische Komponenten 7 können ausserhalb der ringförmigen Abschirmung 3 auf dem Keramiksubstrat 4 angeordnet sein. Die elektrischen Verbindungen zwischen dem Magnetfeldsensor 1 und den Komponenten 7 sind durch Leiterbahnen auf dem Keramiksubstrat 4 oder durch gebondete Drahtverbindungen ausgeführt.

Die Fig. 8 zeigt eine Ausführung der Messanordnung in Planartechnik. In einem Siliziumsubstrat 8 vom Leitfähigkeitstyp P ist eine kreisringförmige Wanne eingeätzt. Quer zur Wanne sind Schwellen 5 vom Leitfähigkeitstyp $N^+$ eindiffundiert. Mit galvanischen Methoden ist im Inneren der Wanne eine Abschirmung 2 aus magnetisch leitendem Material eingebracht. Mit Isolationsschichten 9 und 10 aus $SiO_2$, die vor und nach der galvanischen Behandlung aufgebracht wurden, ist die Abschirmung 2 allseitig elektrisch isoliert. Ueber den inneren und äusseren Enden der Schwellen 5 sind in den Isolationsschichten 9 und 10 Durchbrüche für Anschlusskontakte vorhanden. Mit Brücken 11 aus aufgedampftem Aluminium ist jeweils das innere Ende einer Schwelle 5 mit dem jeweils äusseren Ende einer nächsten Schwelle 5 verbunden. Die Schwellen 5 und die Brücken 11 bilden in ihrer Gesamtheit die Erregerspule 3. Im Zentrum der kreisringförmigen Abschirmung 2 ist im Siliziumsubstrat 8 der Magnetfeldsensor 1 integriert. Der Magnetfeldsensor 1 misst Magnetfelder $H_a$, die parallel zum Siliziumsubstrat 8 verlaufen. Weitere elektronische Funktionseinheiten können ausserhalb der kreisringförmigen Abschirmung 2 angeordnet sein und mit der Erregerspule 3 und dem Magnetfeldsensor 1 verbunden sein.

In der Fig. 9 sind der Magnetfeldsensor 1, die Abschirmung 2 und die Erregerspule 3 derart in einer Stromschlaufe 12 angeordnet, dass das von der Stromschlaufe 12 ausgehende Magnetfeld $H_a$ vom Magnetfeldsensor 1 erfasst wird. Stromschlaufen dieser Art werden z. B. in statischen Elektrizitätszählern eingesetzt. Mit einem Hall-Elemente als Magnetfeldsensor 1 kann auf bekannte Art und Weise direkt die elektrische Leistung der an den Elektrizitätszähler angeschlossenen Verbraucher gemessen werden. Unter Verwendung der in der Fig. 7 gezeigten Hybridtechnik oder der in der Fig. 8 gezeigten Planartechnik lässt sich der Aufbau der Messwerke von Elektrizitätszählern bedeutend vereinfachen.

In der Fig. 10 ist eine vollständige Messanordnung mit dem Magnetfeldsensor 1, der Abschirmung 2, der Erregerspule 3, einem Impulsgenerator 13, einem Verstärker 14, einem Gleichrichter 15 und einem Messinstrument 16 dargestellt. Der Ausgang des Impulsgenerators 13 ist mit der Erregerspule 3 verbunden. Die vom Impulsgenerator 13 gelieferten Stromimpulse i treiben die Abschirmung 2 zeitweise in die Sättigung. Das Magnetfeld $H_a$

wird dadurch zerhackt. Die am Ausgang des Magnetfeldsensors 1 erhaltenen Impulse werden als Wechselstromsignal weiterverarbeitet. Sie werden dem Verstärker 14 zugeleitet und mit diesem proportional verstärkt. Der Ausgang des Verstärkers 14 ist mit dem Gleichrichter 15 verbunden, der das verstärkte Wechselstromsignal gleichrichtet und dem Messinstrument 16 zuführt.

Das beschriebene Prinzip zum Zerhacken des zu messenden Magnetfeldes $H_a$ eignet sich für verschiedene Magnetfeldsensoren, z. B. Magnetodioden, Magnetotransistoren oder Hall-Elemente. Als Vorteil ist zu sehen, dass bereits die Messgrösse $H_a$ zerhackt wird und nicht erst das Ausgangssignal des Magnetfeldsensors 1. Damit wird das 1/f Rauschen und der Offset des Magnetfeldsensors 1 und der nachfolgenden Verstärkerelemente eliminiert. Im weiteren ist hervorzuheben, dass zum Zerhacken des Magnetfeldes $H_a$ nur ein sehr kleiner Energiebedarf notwendig ist. Der kleine Energiebedarf ist bei Anwendungen in Registriergeräten, z. B. Elektrizitätszählern, von grosser Bedeutung. Bei Verwendung von mehreren Magnetfeldsensoren 1 lässt sich nicht nur die Stärke, sondern auch die Richtung eines Magnetfeldes $H_a$ messen. Durch kreuzweises Anordnen von zwei Hall-Elementen innerhalb der Abschirmung 2 kann ein elektronischer Kompass realisiert werden.

## Ansprüche

1. Vorrichtung zur Messung eines magnetischen Feldes mittels eines Magnetfeldsensors (1), dadurch gekennzeichnet, dass eine steuerbare magnetische Abschirmung (2) den Magnetfeldsensor (1) zeitweise vom zu messenden Magnetfeld ($H_a$) abschirmt.

2. Vorrichtung nach Anspruch 1, dadurch gekennzeichnet, dass die Abschirmung (2) mit Hilfe einer Erregerwicklung (3) zeitweise in die Sättigung gebracht wird.

3. Vorrichtung nach Anspruch 1 oder 2, dadurch gekennzeichnet, dass die Abschirmung (2) aus amorphem Metall (Metallglas) besteht.

4. Vorrichtung nach einem der vorhergehenden Ansprüche, dadurch gekennzeichnet, dass die Abschirmung (2) einen zylinderförmigen Hohlkörper bildet, der den Magnetfeldsensor (1) umschliesst.

5. Vorrichtung nach einem der vorhergehenden Ansprüche, dadurch gekennzeichnet, dass die Abschirmung (2) aus zwei magnetisch leitenden Schichten (2a, 2b) besteht, die parallel zueinander angeordnet sind, und dass im Luftspalt zwischen den beiden magnetisch leitenden Schichten (2a, 2b) der Magnetfeldsensor (1) angeordnet ist.

6. Vorrichtung nach einem der Ansprüche 1 bis 3, dadurch gekennzeichnet, dass die Abschirmung (2) ringförmig und die Erregerspule (3) toroidförmig ist, dass der Magnetfeldsensor (1), die Abschirmung (2) und die Erregerspule (3) auf einem gemeinsamen Substrat (4; 8) angeordnet sind und dass die Erregerspule (3) aus zur ringförmigen Abschirmung (2) radial angeordneten Schwellen (5) sowie aus gebondeten Drähten (6) oder aufgedampften Brücken (11) besteht.

7. Vorrichtung nach einem der vorhergehenden Ansprüche, dadurch gekennzeichnet, dass der Magnetfeldsensor (1) ein Hall-Element ist.

8. Vorrichtung nach einem der vorhergehenden Ansprüche, dadurch gekennzeichnet, dass der Magnetfeldsensor (1) an einen Verstärker (14) und einen Gleichrichter (15) angeschlossen ist.

9. Vorrichtung nach einem der vorhergehenden Ansprüche, dadurch gekennzeichnet, dass die Abschirmung (2) und der Magnetfeldsensor (1) derart innerhalb einer Stromschlaufe (12) angeordnet sind, dass das vom Magnetfeldsensor (1) erfasste Magnetfeld von der Stromschlaufe (12) gebildet wird.

10. Verwendung der Vorrichtung nach Anspruch 9 in einem statischen Elektrizitätszähler.

11. Verwendung der Vorrichtung nach einem der Ansprüche 1 bis 8 in einem elektronischen Kompass.

Fig. 1

Fig. 2

Fig. 3

Fig. 4

Fig. 5

Fig. 6

**Fig. 7**

**Fig. 8**

**Fig. 9**

**Fig. 10**

PA 2422

| | Europäisches Patentamt | EUROPÄISCHER RECHERCHENBERICHT | Nummer der Anmeldung |
|---|---|---|---|

EP 89 11 2102

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | US-A-2 786 179 (D.C. ARNOLD et al.) <br> * Spalte 1, Zeilen 18-31; Spalte 2, Zeile 72 - Spalte 3, Zeile 2; Figuren 1,7; Anspruch 1 * | 1,2,4, 11 | G 01 R 33/02 |
| Y | | 3,7-8 | |
| A | | 6 | |
| D,Y | EP-A-0 157 470 (STANDARD TEL. AND CAB.) <br> * Seite 8, Zeilen 2-26; Figur 5; Ansprüche 1,2 * | 3,7-8 | |
| A | FR-A-2 352 307 (MISHIMA KOSAN CO.) <br> * Seite 2, Zeilen 14-32; Anspruch 1 * | 1 | |
| A | US-A-3 803 482 (E. STEINGROEVER) | | |
| A | US-A-3 564 401 (G.W. COON) | | |

RECHERCHIERTE SACHGEBIETE (Int. Cl.5)

G 01 R 33

Der vorliegende Recherchenbericht wurde für alle Patentansprüche erstellt

| Recherchenort | Abschlußdatum der Recherche | Prüfer |
|---|---|---|
| DEN HAAG | 06-12-1989 | HAASBROEK J.N. |